(19) Europäisches Patentamt
European Patent Office
Office européen des brevets

(11) **EP 4 443 173 A1**

(12) **EUROPEAN PATENT APPLICATION**

(43) Date of publication:
**09.10.2024 Bulletin 2024/41**

(21) Application number: **23166603.3**

(22) Date of filing: **04.04.2023**

(51) International Patent Classification (IPC):
**G01R 15/20** (2006.01)    **G01R 19/00** (2006.01)
**G01R 19/25** (2006.01)

(52) Cooperative Patent Classification (CPC):
**G01R 15/207; G01R 19/0092; G01R 19/25**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Pucki GmbH
82362 Weilheim (DE)**

(72) Inventors:
• **BOLL, Hans-Peter
  18258 Kassow (DE)**
• **VON BRAUN, Max
  82362 Weilheim (DE)**

(74) Representative: **Reitstötter Kinzebach
Patentanwälte
Sternwartstraße 4
81679 München (DE)**

(54) **METHOD AND DEVICE FOR NON-INTRUSIVE CURRENT MEASUREMENT IN A MULTI-CONDUCTOR CABLE**

(57) The present invention concerns a method and a handheld device for non-intrusive current measurement in a multi-conductor cable, wherein the method comprises the steps of:

a) arranging a multi-conductor cable having a number (N) of individual conductors in an aperture (12, 102) of a sensor head (11, 101), said aperture having a central axis (A) extending in a third direction (z), said sensor head (11, 101) having an inner surface (13, 116, 117) defining a circumference of said aperture (12, 102) and a multiplicity of magnetic sensors (15, 16, 17, 118, 119) arranged at a number (L) of different locations at said inner surface (13, 116, 117), said number (L) of different locations being larger than said number (N) of individual conductors;

b) performing a number (M) of measurements at a sampling frequency (fs) of a magnetic field ($\vec{H}$) in a first direction (x) making a first angle with said third direction (z) and in a different second direction (y) making a second angle with said third direction (z), at each of said number (L) of different locations, to obtain said number (M) of measurement data for each of said first and second directions (x, y);

c) performing a harmonic analysis, preferably a discrete Fourier transformation, on each set of said number (M) of measurement data for each of said first and second directions (x, y) to obtain frequency distributions of said measurement data;

d) determining a current frequency (fc) of electrical currents (I) flowing in said multi-conductor cable;

e) selecting magnetic field amplitude coefficients which correspond to said current frequency (fc) from said frequency distributions of said measurement data to obtain a first component ($H_x$) of said magnetic field ($\vec{H}$) in said first direction (x) and of a second component ($H_y$) of said magnetic field ($\vec{H}$) in said second direction (y) at each of said number (L) of different locations; and

f) calculating electrical currents values ($I_j$) for currents flowing in each conductor of said multi-conductor cable from said first and second components ($H_x$, $H_y$) of said magnetic field ($\vec{H}$) at each of said number (L) of different locations.

EP 4 443 173 A1

**Description**

The present invention concerns a method and a device for non-intrusive measurements of electrical currents flowing in a multi-conductor cable, especially a hand-held device for non-intrusive measurements of electrical current.

Conventionally, so-called ammeters, which is an abbreviation of Ampere meters, are used to measure electrical current in a circuit. Typically, ammeters are directly connected in series within the circuit in which the current is to be measured. Such a device is allow for the most precise measurement of electrical current flowing in a single conductor. However, often it is not possible or not desired to integrate a measurement device directly into a circuit. Therefore, measurement devices have been developed which allow for a non-intrusive measurement of electrical currents in electrical conductors. A typical example is a so-called *"current clamp"*, which is an electrical device provided with movable clamps, jaws or brackets, which can be arranged around an electrical conductor. There are various types of current clamps such as the current transformer type, where the clamp comprises a split ring made of ferrite or soft iron with a wire coil wound around one half or both halves forming one winding of a current transformer, while the electrical conductor to be measured forms the other winding. The current transformer type can be used to measure alternating current (AC). Other types, such as the iron vane type or the Hall effect type, are able to measure both, direct current (DC) and AC. Typical clamp meters are, however, limited to measuring the electrical current in a single conductor because in a multi-conductor cable external effects, such as magnetic fields induced by electrical charges within the conductors, are increasingly complicated and, more importantly, fully or partially cancel at least in the far field, so that any inference from measured magnetic fields to the electrical current flowing in the individual conductors is rather difficult. For instance, in a two-conductor cable, there is one outgoing conductor and one return conductor, which generates opposing magnetic fields, which, at some distance from the conductors, essentially cancel each other.

In order to solve this problem, several solutions have been proposed in prior art. For instance, U.S. Patent Application US 2012/0319676 A1 describes a current sensing device, which includes multiple semiconductor magnet field sensors integrated in a housing that can be detachably coupled to a multi-conductor cable, and which provides one or more outputs indicative of the currents passing through the multiple conductors in the cable. US 2012/0319676 A1 does, however, not describe how currents are determined from the output of the individual sensors. This prior art document only describes the case for a two-conductor cable in more detail, indicating that depending on the individual locations of the sensors, each sensor will couple more or less to either of the two conductors, but cautions that measurements made with this system provide merely a signature of the current in the cable but not necessarily an absolute current of a power magnitude.

International Patent Application WO2015/144541 A2 describes a similar device, namely a device for permanent, non-contact measurement of current strength in sheathed conductors, which comprises a sensor head in the form of a cuff with multiple magnetic field sensors arranged therein. This document describes that the effectively flowing currents in the individual conductors are calculated using previously empirically determined algorithms for the mathematical description of the relationship between a current in individual conductors of a conductor bundle and the magnetic fields which they generate. The system described in this document requires an adaptation of the position of the magnetic field sensors within the claw, both in terms of their circumferential position and in terms of their orientation of their plane with respect to the circumferential line of the claw.

International Patent Application WO2013/068360 A1 describes a device for measuring currents in the conductors of a sheathed cable of a poly-phase network, which uses at least three magnetic sensors arranged around a central orifice intended to be traversed by the cable to be measured, where the number of conductors is less than the number of sensors. The currents in the individual cables are determined by formed a vector [B], which includes a measurement of the magnetic field of each of the sensors and calculating a vector [I] for the currents flowing through the cable, having a given cable configuration by accessing a library of matrices [K] and [K]$^+$, where [K]$^+$ is a pseudo-inverse matrix of the matrix [K] and selecting the matrices such that a residual vector [R], calculated on the basis of [K], [K]+ and [B] for various configurations of cables and various angular positions of said sensors with respect to these cables is minimal.

The technical problem underlying the present invention resides in providing a method and an easy-to-use handheld device for determining the electrical current flowing in a multi-conductor cable, which is more precise and more reliable than prior art methods.

This technical problem is solved by the method of present claim 1 and the device of present claim 13. Preferred embodiments of the present invention are subject of the dependent claims.

Accordingly, the present invention concerns a method for non-intrusive current measurement in a multi-conductor cable, comprising the steps of:

    a) arranging a multi-conductor cable having a number N of individual conductors in an aperture of a sensor head, said aperture having a central axis A extending in a third direction z, said sensor head having an inner surface defining a circumference of said aperture and a multiplicity of magnetic sensors arranged at a number L of different locations at said inner surface, said number L of different locations being larger than said number N of individual conductors;

b) performing a number M of measurements at a sampling frequency fs of a magnetic field $\vec{H}$ in a first direction x making a first angle with said third direction z and in a different second direction y making a second angle with said third direction z, at each of said number L of different locations, to obtain said number M of measurement data for each of said first and second directions x, y;

c) performing a harmonic analysis on each of said number M of measurement data for each of said first and second directions x, y to obtain frequency distributions of said measurement data;

d) determining a current frequency fc of electrical currents I flowing in said multi-conductor cable;

e) selecting magnetic field amplitude coefficients which correspond to said current frequency fc from said frequency distributions of said measurement data to obtain a first component $H_x$ of said magnetic field $\vec{H}$ in said first direction x and of a second component $H_y$ of said magnetic field $\vec{H}$ in said second direction y at each of said number L of different locations; and

f) calculating electrical currents values $I_j$ for currents flowing in each conductor of said multi-conductor cable from said first and second components $H_x$, $H_y$ of said magnetic field $\vec{H}$ at each of said number L of different locations.

Like prior art cited above, the present invention implies the concept of using magnetic sensors arranged around a multi-conductor cable to detect magnetic fields generated by electrical currents flowing in the respective conductors of the cable. To this effect, the multi-conductor cable is arranged in an aperture of a sensor head, which has an inner surface defining a circumference of the aperture. A multiplicity of magnetic sensors is arranged at a number L of different locations at the inner surface of the sensor head. Typically, as the cable is an extended object, the aperture will have a central axis A, which corresponds to the longitudinal axis of the cable, when arranged in the aperture. The aperture is typically arranged in a plane defined by a first direction x and a second direction y, while the central axis A extends in a third direction z.

According to the method of the present invention, the magnetic field is measured at least in the first direction x and the second direction y, which is different, specifically not parallel, to the first direction. In general, the first direction x, the second direction y and the third direction z can be considered as the basic directions of a three-dimensional coordinate system. Preferably, the first direction and the second direction lie in the plane of the aperture of the sensor head such that the first direction x makes a first angle with the third direction z, and the second direction y makes a second angle with the third direction z.

The number L of different locations, where magnetic sensors are arranged, depends on the type of magnetic sensors used. The number L of different locations has to be larger than the number N of individual conductors in the multi-conductor cable. For instance, if magnetic sensors are used, which can simultaneously measure components of the magnetic field in at least the x and y direction, then one magnetic sensor is arranged at each location, so that the number of magnetic sensors corresponds to the number L of different locations. If magnetic sensors are used, which can measure a magnetic field component only in one direction, then the number of magnetic sensors is twice the number L of different locations, because at each location, at least two magnetic sensors have to be employed.

As the magnetic fields generated by currents flowing in a multi-conductor cable produce a rather complicated magnetic field pattern, where magnetic field components generated by one conductor might even cancel with magnetic field components generated by another conductor and where typically additional external magnetic field components are present, the present invention does not use the magnetic field measured by the magnetic sensors directly. Rather, the method of the present invention suggests performing a harmonic analysis on the initial measurement results obtained via the magnetic sensors, for instance a linear transformation mapping the time-dependent measurement results into the frequency domain, for instance a discrete Fourier transformation. Other transformations can also be employed, for instance a Z-transform or a discrete Hartley transform. In the case of a discrete Fourier transform, a number M of measurements at a sampling frequency fs is performed in each of the first direction x and the second direction y, respectively. The discrete Fourier transformation is performed on each set of a M measurement data for each of the first and second directions x, y. The discrete Fourier transformation will result in a frequency distribution of the measurement data.

In a next step, a current frequency Fc of electrical currents flowing in the multi-conductor cable is determined. The term "current frequency" does not only refer to alternating current (AC) but comprises also direct current (DC), i.e. the current frequency can be larger or equal to zero (0). In the context of the present invention, the term "determined" usually means a determination via measurement but is also possible that current frequency is known in advance so that "determined" can also mean "selected based on prior knowledge". In certain embodiments, AC and DC components can be measured simultaneously. Then, only the magnetic field amplitude coefficients, which correspond to the determined current frequency Fc, are selected to obtain a first component $H_x$ of the magnetic field in the first direction x and a second component $H_y$ of the magnetic field in the second direction y at each of the L different locations. It should be noted that the actual measured quantity is the magnetic flux density B, which is related to the magnetic field strength H through the vacuum permeability ($H = B / \mu_0$). Finally, the electrical current values $I_J$ for the currents flowing in each conductor are calculated from the first and second components $H_X$, $H_Y$ of the magnetic field at each of the number L of different locations.

The harmonic analysis, especially the discrete Fourier transformation performed according to the method of the present invention essentially corresponds to a frequency filtering of the measured data, thus increasing the accuracy of the method of the present invention and allowing to perform the method of the present invention in a real-world environment, where different sources of magnetic fields interfere with each other.

The calculated current values can be further processed in different manners. For instance, the calculated current values can be sent to user-specific software applications, where they can be processed depending on the requirements of the specific application. Typically, however, the calculated electrical current values will be displayed in a numerical or graphical form. Consequently, in one embodiment, the method of the present invention further comprises the step of g) displaying said calculated electrical current values $I_j$. For instance, the method of the present invention can be implemented in a measurement device having an integrated display showing calculated electrical current values as numerical values or on a chart as graphical values. The measured electrical current values can also be transferred to a stationary or mobile computer device, such as a mobile phone or a tablet computer, which runs a software application for displaying the calculated electrical current values.

The number of measurements at sampling frequency fs are at least performed once in order to obtain the required minimum data set for performing a discrete Fourier transformation. Preferably, however, the number of M measurements are repeated sequentially. Therefore, in one embodiment of the method of the present invention, the above described steps b) to g) are repeated during consecutive measurement cycles. In this case, when displaying the calculated electrical current values, it can be advantageous to display only an average value over several measurement cycles in order to have a smoother visual representation of the measurement data.

Preferably, the harmonic analysis, specifically the discrete Fourier transformation, used in step c) of the method of the present invention is a Fast Fourier Transformation (FFT). FFT is a fast and efficient algorithm for implementing a discrete Fourier transformation.

When FFT is used as a discrete Fourier transformation, the number M of measurements is preferably selected from the group consisting of 128, 256, 512, 1024 and 2048. Other values for the number M of measurements can, however, also be employed. Typical number of measurements, usually denoted as "block length", is an integer power to base 2, for instance $2^{12}$ corresponds to a block length of 4,096 samples. However, a larger block length increases the time required for one measurement (measurement time for one measurement cycle = block length / sample frequency).

The sample frequency not only influences the measurement time, but also the band width, i.e. the theoretical maximum frequency, which can be evaluated via an FFT, also denoted Nyquist frequency. Accordingly, the sampling frequency fs should at least be twice as high as the current frequency fc of electrical currents flowing in the multi-conductor cable. In one embodiment of the method of the present invention, the sampling frequency fs is selected from a range of 200 Hz to 3.2 kHz. Preferably, the sampling frequency fs is selected from a range of 400 Hz to 1 KHz.

As indicated above, the first direction x and the second direction y lie preferably within the same plane, mainly the plane of the aperture of the sensor head. Preferably, the search direction z, i.e. the direction in which the multi-conductor cable extends when arranged within the sensor head, is perpendicular to the claim established by the first direction x and the second direction z. In such an embodiment, measurements of the magnetic field components $H_x$ and $H_y$ in the first and second directions, respectively, is sufficient to calculate the electrical currents flowing in each conductor, because the magnetic field pattern is independent from the z-direction as long as the cable is perfectly aligned in the third direction z.

However, measurement of the magnetic field component $H_z$ in the third direction z can be used to verify that the cable is correctly aligned. Accordingly, if the magnetic field component in the third direction z is measured, this measurement can be used to properly align the cable by minimizing the corresponding magnetic field component $H_z$. Consequently, in one embodiment of the method of the present invention, the first direction x is perpendicular to said third direction z, and said second direction y is perpendicular to said third direction z, and wherein said step b) further comprises performing said number M of measurements at said sampling frequency fs of a magnetic field $\vec{H}$ in said third direction z. The measured component of the magnetic field in the search direction z, i.e. $H_z$, can be displayed as a numerical value. Alternatively, as the magnetic field component $H_z$ is essentially an indication of a correct alignment of the multi-conductor cable in the sensor head; this value can be used as a mere indication of the correct alignment, for instance by displaying an error when the magnetic field component $H_z$ exceeds a pre-defined threshold.

In order to distinguish between magnetic field components induced by currents flowing in the multi-conductor cable and other external sources of magnetic fields, reference measurements can be conducted. For instance, if it is feasible to switch the electrical current on and off, measurements during the off-phase can be used as reference measurements. As this is not always feasible, in certain embodiments, magnetic field measurements obtained by reference magnetic sensors can be employed. In one embodiment of the method of the present invention, the sensor head further comprises at least one reference magnetic sensor spaced apart from said inner surface of said aperture of said sensor head. The first and second components $H_x$, $H_y$ of said magnetic field $\vec{H}$ are obtained by including corrections $Href_x$, $Href_y$ obtained from said at least on reference magnetic sensor. The at least one reference magnetic sensor is arranged at a distance from the center of the multi-conductor cable which is at least twice the distance, preferably, at least five times the distance and particularly preferred at least ten times the distance of the distance of the magnetic sensors used for measuring the magnetic field components $H_x$ and $H_y$.

The current frequency fc can either be a pre-determined frequency, for instance if it is known, that the current frequency is the regular net frequency, all can be determined experimentally from the measured magnetic field.

In one embodiment of the method of the present invention, the in step d) said current frequency fc is a pre-selected current frequency. This variant is particularly preferred if the current frequency is known in advance.

If the current frequency fc is not known in advance, the frequency can be determined from the data of the discrete Fourier transformation. Often, the coefficient with the largest frequency component can be considered as representing the current frequency fc. However, as the corresponding frequency resolution ∆ f is equal to the sample frequency fs divided by the block length, a higher resolution can be obtained by varying the sample frequency. Accordingly, in another embodiment of the method of the present invention, in step d) said current frequency fc is determined by varying said sampling frequency fs in step b) in consecutive measurement cycles and by selecting in step e) the frequency having the largest magnetic field amplitude coefficient as the current frequency fc. Typically, the sample frequency fs is varied by at least 10 % of the expected current frequency fc.

The electrical current values in each conductor can be calculated from the first and second components of the magnetic field in various manners.

According to one embodiment of the method of the present invention, in step f), said electrical currents values $I_j$ for currents flowing in each conductor of said multi-conductor cable are calculated from a trained artificial intelligence model. Accordingly, an artificial intelligence model can, for instance be trained by using a multitude of different cable configurations, which can vary in terms of the number of conductors, the geometrical arrangement of the conductors within the cable, i.e. especially the distance of the conductors from one another and in terms of the electrical current values and current frequencies and possible phase differences of the currents flowing through each individual conductor. From a given configuration, it is straightforward to calculate the resulting components of the magnetic field at the location of each magnetic sensor. The inverse operation, i.e. calculating the respective currents from measured magnetic field components, is, however, not analytically solvable. However, a correspondingly trained artificial intelligence model is able to assign a certain electrical current parameter set to an observed pattern of magnetic field components. The training of the artificial intelligence model does not have to be conducted experimentally, i.e. by passing certain currents through various configurations of cables and actually measuring the resulting magnetic field components, but by simulating magnetic field patterns based on certain model calculations of cable configurations. Accordingly, a huge training set for the artificial intelligence model can be efficiently provided at low cost.

Alternatively, the equations determining the magnetic field strength at the location of the magnetic sensors can be formulated analytically, while the inverse operation has to be solved numerically.

In another embodiment of the method of the present invention, in step f), said electrical currents values $I_j$ for currents flowing in each of *N* individual conductors, i.e. *j = 1 to N,* of said multi-conductor cable, are calculated from magnetic field measurements of *L* magnetic sensors for the x- and y-components, respectively, arranged at different locations, by numerically solving equations

$$H_{ix} = -\frac{1}{2\pi}\left(\sum_{j=1}^{N} I_j \frac{\Delta y_{ij}}{r_{ij}^2}\right)$$

and

$$H_{iy} = \frac{1}{2\pi}\left(\sum_{j=1}^{N} I_j \frac{\Delta x_{ij}}{r_{ij}^{2}}\right)$$

for $i = 1\ to\ L$, wherein $r_{ij}$ is the distance between magnetic sensor $i$ and conductor $j$ and $\Delta x_{ij}$ and $\Delta y_{ij}$ are the respective x- and y-components of said distance.

Preferably, the origin of the x-y-coordinate system is located at one pre-determined magnetic sensor. If all magnetic sensors used in the sensor head are run the same type, such a selection of the origin of the coordinate system allows to compensate for absolute locations and absolute dimensions of the multiplicity of magnetic sensors, so that only the relative arrangement of the sensors to the sensor chosen as origin are relevant for evaluating the numerical solution.

Accordingly, a much greater precision than the actual dimensions of the magnetic sensor can be obtained assuming that all sensors respond similarly to magnetic fields in their surrounding.

Various methods for solving the above equations can be implied, for instance a modified Newton algorithm and the like.

The present invention also concerns a handheld device for non-intrusive current measurement in a multi-conductor cable comprising:

a sensor head comprising an aperture defined by an inner surface of said sensor head , said aperture having an inner diameter (D) and a central axis (A), and a multiplicity of magnetic sensors arranged at a number of different locations at said inner surface ,

a processing unit functionally connected with said multiplicity of magnetic sensors , said processing unit being configured to execute at least steps b) to f) of the above described method of the present invention. The processing unit can be a microcomputer running a software to execute steps b) to f), and optionally g).

The aperture can have any configuration suitable of arranging the magnetic sensors closely to the multi-conductor cable. As most cables have a circular cross-section, it is preferred that the aperture also has an essentially circular configuration. In this context, the term *"aperture"* does not necessarily imply that it is delimited by a closed circumference, but the circumference can have an opening allowing the introduction of the cable from the outside. Preferably, however, the aperture includes movable parts, which allow to obtain an essentially closed configuration after introduction of the cable to be measured.

If the aperture has an essentially circular configuration, the term "inner diameter" refers to the actual inner diameter of the circle. However, the aperture can also exhibit any suitable non-circular configuration, for instance a U-shaped configuration or an elliptical configuration. In these cases, measurement of cables having a circular cross-section will still be the most relevant application. Therefore, in the context of the present invention, for apertures exhibiting a non-circular configuration, the "inner diameter" of the aperture refers to the diameter of the largest circle which can be inscribed into the aperture.

In one embodiment of the device of the present invention, the aperture is defined by at least two sections of said sensor head, which are movable with respect to each other in order to provide an aperture with variable diameter D. The two sections can be configured as movable clamps or jaws, which, in the closed position, result in a more or less circular configuration. With only two sections, such a circular configuration can only be approximated; in an alternative embodiment, the sections consist of a multiplicity of lamellar elements, which allow a better approximation of a circular approach, essentially similar to a lamellar diaphragm often used in photographic cameras. Depending on the configuration of the sections and the resulting diameter of the aperture, certain magnetic sensors of the multiplicity of magnetic sensors can be less effective in determining the magnetic field components because they might be arranged at a greater distance from the multi-conductor cable than other magnetic sensors. Therefore, the device and method of the present invention also provide for selecting only a sub-set of the multiplicity of magnetic sensors for evaluating the currents flowing through the conductors, provided that the sub-set still meets the requirement that the resulting number of locations is larger than the number of individual conductors in the cable.

In one embodiment of the device of the present, the sensor head comprises guiding means which ensure a perpendicular alignment of a section of the cable passing through the aperture with respect to a plane in which the multiplicity of magnetic sensors are arranged. The guiding means can comprise an open channel essentially extending a certain length from the aperture in a direction perpendicular to the aperture. Preferably, the guiding means extend from both sides of the aperture. For typical electrical cables, the certain length can be in a range of 5 to 40 mm, preferably from 10 to 30 mm.

In one embodiment of the device of the present invention, the processing unit comprises a microprocessor arranged in said sensor head and a mobile device removably connectable to said sensor head. In such an embodiment, the implementation of the method of the present invention can be distributed between the microprocessor arranged in the sensor head and the microcomputer arranged in the mobile device. For instance, a microprocessor in the sensor head can essentially implement the data acquisition and data communication processes, while the actual evaluation of the magnetic fields in order to calculate the respective electrical currents is handled by the microcomputer of the mobile device.

The invention will now be described in more detail in connection with an embodiment depicted in the accompanying drawings.

In the drawings:

Fig. 1    shows a schematic cross-sectional view of one embodiment of a handheld device according to the present invention, having a sensor head with a U-shaped aperture; and

Fig. 2    shows a schematic cross-sectional view of another embodiment of a handheld device of the present invention having a sensor head with variable aperture.

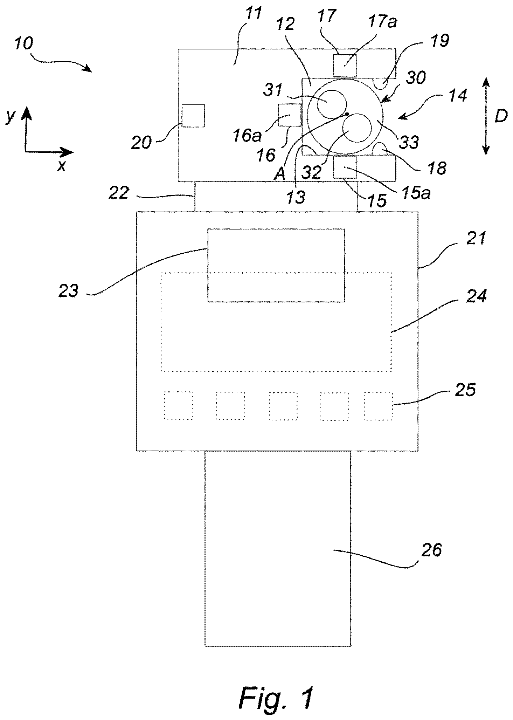

In Fig. 1 a schematic cross-sectional view of a first embodiment of a handheld device 10 according to the present invention is shown. The handheld device 10 comprises a sensor head 11 having a U-shaped aperture 12 which is defined by an inner surface 13 of the sensor head 11. The aperture has a central axis A which is perpendicular to the plane of the drawing. The U-shaped aperture 12 has an open side inlet 14 that allows insertion of a cable. In the embodiment of Fig. 1, the sensor head 11 is provided with three magnetic sensors, namely a first magnetic sensor 15, a second magnetic 16, and a third magnetic sensor 17. The three magnetic sensors 15, 16, 17 are arranged in a T-shaped configuration at three different locations at the inner surface 13 of the sensor head 11. In the present example, each magnetic sensor 15, 16, 17 is a fully integrated 3-axis magnetometer with integrated electronic circuits. Such magnetometers are commercially available, e.g. the AMR magnetometer MMC5983MA, manufactured by the company MEMSIC Semiconductor Co., Ltd. This MEMSIC magnetometer has a measurement range of +/- 800 $\mu$T and allows of up to 18 bits operation corresponding to an resolution of 0.006 $\mu$T. At 16 bits operation, the resolution is still 0.024 $\mu$T. The MEMSIC magnetometer of this embodiment has dimensions of 3 x 3 x 1 mm. However, using identical magnetic sensors in the sensor head and choosing the same location on each magnetic sensor as reference points to which the measured magnetic fields refer, e.g. the centers 15a, 16a, 17a of each magnetic sensor 15, 16, 17, respectively, allows for a much higher spatial resolution, because the internal arrangements and the exact point of maximum sensitivity within the sensor do not matter under these circumstances, provided that these features are essentially the same for all sensors installed. A configuration according to the first embodiment using three two-axis or three axis magnetometers allows the evaluation of currents in cables having two conductors. In this embodiment, the U-shaped aperture 12 of the sensor head 11 has an inner diameter D of 12 mm allowing to accommodate most common two-conductor cables and can be provided with inwardly facing first and second protrusions 18, 19 near the side inlet 14 allowing to maintain a cable 30 to be investigated, also shown schematically in Fig. 1, in place. For the present example of a U-shaped aperture, the inner diameter essentially corresponds to the width in the y-direction of Fig. 1 (see coordinate system indicated in the Fig. 1).

In Fig. 1, the cable 30 has two conductors 31, 32 surrounded by a protective sheath 33. Usually, the sheath is made from a flexible plastic material allowing the cable to be squeezed through the gap formed between the first and second protrusions 18, 19. The protrusions 18, 19 can also be made from material exhibiting some flexibility to avoid damage of the cable.

As can be taken from Fig. 1, in this embodiment, the sensor head 11 further comprises a reference magnetic sensor 20 which is arranged at much a larger distance from the cable 30 than the magnetic sensors 15, 16, 17. The reference magnetic sensor is typically employed to correct for external magnetic fields if DC currents are to be measured in the cable or, if AC currents are measured, if the measurement takes place in an environment having a strong background at the measurement frequency.

In the embodiment of Fig. 1, the handheld device 10 comprises a body 20 to which the sensor head 11 is removably attached via a connector 21. The connector 21 provides not only a mechanical connection between sensor head 11 and body 20 but also a data connection between magnetic sensors 15, 16, 17, the reference magnetic sensor 20 and a microprocessor 23 arranged in the body 21. The microprocessor 23 is programmed to carry out the method of the present invention. The body 20 of the handheld device 10 further comprises a display 24 and control buttons or control knobs 25 for data output/visualization and data input. As the display 24 and the control buttons/knobs 25 are shown in dotted lines because these elements are not arranged in the plane of the cross-sectional view of Fig. 1. Finally, the body 11 is provided with a handle 26 which can be grasped by the user.

Based on the geometrical configuration of Fig. 1, the two-conductor cable (N=2) can be evaluated as follows:

- Given values are the known locations of the first magnetic sensor 15, the second magnetic sensor 16 and the third magnetic sensor 17, i.e. the coordinates in the x-y-coordinate system in the plane of Fig. 1: $(m_{1x}, m_{1y})$, $(m_{2x}, m_{2y})$ and $(m_{3x}, m_{3y})$. The origin of the coordinate system and be anywhere with respect to the sensor head but is preferably chosen to be in the center (or any other pre-selected point) on one of the magnetic sensors, e.g. the first magnetic sensor such that $m_{1x}=0$ and $m_{1y} = 0$.

- Measured values are the magnetic B-field components measured by the three magnetic sensors ($L$=3) in the x-y plane which can be converted into corresponding magnetic H-field components, i.e. $(H_{1x}, H_{1y})$, $(H_{2x}, H_{2y})$ and $(H_{3x}, H_{3y})$.

- Unknowns are the currents $I_1$, $I_2$ flowing in each cable and the exact location of each of the two conductors in the cable $(x_1, y_1)$, $(x_2, y_2)$.

These six unknowns are related to the known and measured values via the following six equations, where the distance $r_{ij}^2$ between magnetic sensor $i$ and conductor $j$ is expressed in terms of the respective x and y components $(m_{ix}-x_j)^2$ and $(m_{iy}-y_j)^2$:

$$H_{1x} = -\frac{I_1}{2\pi}\left(\frac{m_{1y} - y_1}{(m_{1x} - x_1)^2 + (m_{1y} - y_1)^2}\right) - \frac{I_2}{2\pi}\left(\frac{m_{1y} - y_2}{(m_{1x} - x_2)^2 + (m_{1y} - y_2)^2}\right)$$

$$H_{1y} = \frac{I_1}{2\pi}\left(\frac{m_{1x} - x_1}{(m_{1x} - x_1)^2 + (m_{1y} - y_1)^2}\right) + \frac{I_2}{2\pi}\left(\frac{m_{1x} - x_2}{(m_{1x} - x_2)^2 + (m_{1y} - y_2)^2}\right)$$

$$H_{2x} = -\frac{I_1}{2\pi}\left(\frac{m_{2y} - y_1}{(m_{2x} - x_1)^2 + (m_{2y} - y_1)^2}\right) - \frac{I_2}{2\pi}\left(\frac{m_{2y} - y_2}{(m_{2x} - x_2)^2 + (m_{2y} - y_2)^2}\right)$$

$$H_{2y} = \frac{I_1}{2\pi}\left(\frac{m_{2x} - x_1}{(m_{2x} - x_1)^2 + (m_{2y} - y_1)^2}\right) + \frac{I_2}{2\pi}\left(\frac{m_{2x} - x_2}{(m_{2x} - x_2)^2 + (m_{2y} - y_2)^2}\right)$$

$$H_{3x} = -\frac{I_1}{2\pi}\left(\frac{m_{3y} - y_1}{(m_{3x} - x_1)^2 + (m_{3y} - y_1)^2}\right) - \frac{I_2}{2\pi}\left(\frac{m_{3y} - y_2}{(m_{3x} - x_2)^2 + (m_{3y} - y_2)^2}\right)$$

$$H_{3y} = \frac{I_1}{2\pi}\left(\frac{m_{3x} - x_1}{(m_{3x} - x_1)^2 + (m_{3y} - y_1)^2}\right) + \frac{I_2}{2\pi}\left(\frac{m_{3x} - x_2}{(m_{3x} - x_2)^2 + (m_{3y} - y_2)^2}\right)$$

These equations cannot be resolved for $I_1$, $I_2$ analytically. Rather, AI methods or numerical methods have to be employed.

An example of a suitable numerical method for solving the above referenced six equations for the two unknown currents $I_1$, $I_2$ and the four unknown distances is essentially a modified Newton method and can be summarized as follows:

a) an six-dimensional initial starting vector $\vec{V_0}$ is created having components which are estimated solutions for $I_1$, $I_2$, $r_{1x}$, $r_{1y}$, $r_{2x}$, $r_{2y}$;

b) from the above equations, a six-dimensional error vector $\vec{E_0}$ is determined which indicates the deviation of the measured magnetic field values from those calculated on the basis of the initial starting vector $\vec{V_0}$;

c) an error measure $EM_0$ is determined as the sum of the absolute values of each component of error vector $\vec{E_0}$;

d) a Jacobian 6x6 matrix $J_0$ is calculated which includes the partial derivatives of the above magnetic field equations at the values of the starting vector;

e) the Jacobian is inverted to yield $J_0^{-1}$;

f) a correction vector $\overrightarrow{K_0} = J_0^{-1} * \overrightarrow{E_0}$ is formed;

g) a new starting vector $\overrightarrow{V_1}$ is formed according to $\overrightarrow{V_1} = \overrightarrow{V_0} + \lambda_0 * \overrightarrow{K_0}$, with factor $\lambda_0$ being selected from the range $0 \leq \lambda_0 \leq 1$ by varying $\lambda$ until the error measure functions $EM(\lambda)$ becomes minimal, which can, for instance be achieved using a gradient descent approach;

h) steps b) to g) are repeated with the result g), i.e. determining error vector $\overrightarrow{E_l}$ from starting vector $\overrightarrow{V_l}$, error measure $EM_l$, Jacobian $J_l$, correction vector $\overrightarrow{K_l}$, and new starting vector $\overrightarrow{V_{l+1}}$;

i) loop b) to g) is stopped either when EM is smaller than a pre-defined threshold and the resulting vector $\overrightarrow{V_l}$ is the desired solution, or when a pre-defined number of loops has been reached without EM converging below said threshold;

j) in the latter case of step i), steps a) to i) can be repeated with a new initial starting vector.

The pre-defined threshold can be zero within the accuracy of the computer implementing the above method.

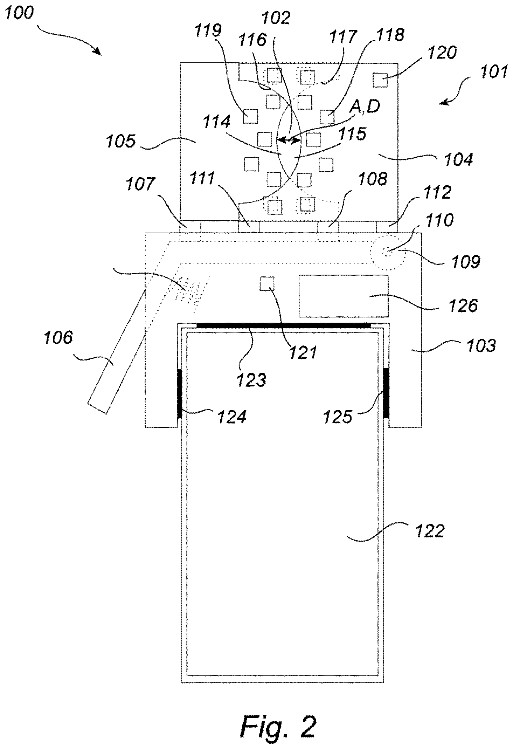

Fig. 2 shows schematically a cross-sectional view of a second embodiment of a handheld device 100 according to the present invention, which comprises a sensor head 101 with variable aperture 102 and a body 103. In Fig. 2, elements which are covered by elements lying in the plane of Fig 2 are shown in dotted lines. In this embodiment, the sensor head 101 comprises two essentially identical first and second sections 104, 105, wherein the second section 105 is pivotable with respect to the static first section 104. To this effect, the second section is attached to a handle 106 by means of feet 107, 108 and the handle 106 is pivotally hinged to a ball bearing 109 arranged around a rotary axis 110 in the body 103 of the handheld device 100. The static first section 104 of the sensor head 101 is attached to the body 103 by means of feet 111, 112. To open or enlarge the aperture 102, the user can grasp the handle 106 and urge it towards the body 103 against the force of a return spring 113. If no force acts upon the handle 106, the return spring 113 urges the second section 105 towards the first section 104, thus defining an aperture 102 with minimum diameter as depicted in Fig. 2. When the handle 106 is pressed against the force of the return spring 113, the second section 105 moves away from the first section 105 allowing to introduce a multi-conductor cable (not depicted in Fig. 2) into the aperture 102 which is in this embodiment defined by two recesses 114, 115 arranged in each of the first and second sections 104, 105 with the first and second section 104, 105 being arranged such that the respective recesses 114, 115 face each other in the closed position. Each recess has an inner surface 116, 117, respectively, at which a multiplicity of magnetic sensors is arranged. In the present embodiment, nine magnetic sensor 118 are arranged in the static first section 104 of the sensor head 101 and nine magnetic sensors are arranged in the pivotable second section 105 of the sensor head 101. When the multi-conductor cable is in circuit into the aperture 102, the handle 106 is released and the return spring 113 acting on the handle 106 urges the second section 105 towards the first section 104 until the diameter of the aperture essentially corresponds to the diameter of the inserted cable. This arrangement allows at least some of the sensors of the sensor head to be as close to the multi-conductor cable as possible, therefore increasing measurement accuracy.

As can also be seen in Fig. 2, the sensor head 101 comprises two reference magnetic sensors 120, 121 spaced further apart from the aperture to allow for a compensation of external magnetic fields. A first reference magnetic sensor 120 is arranged at an opposite side magnet A first reference magnetic sensor 120 is disposed at an end of the first section 104 opposite the recess 114 of the first section. A second reference magnetic sensor 121 is disposed in the body 103, thus being spaced even further apart from the aperture 102 than the first reference magnetic sensor 120.

In the present example, the body 103 of the handheld device 100 is configured as connector interface to be attached to a mobile device, for instance a smart phone 122 which can then serve as a gripping handle of the whole device. In the present embodiment, the body comprises a physical data connector 123 and two mechanical connectors 124, 125 to provide a rigid assembly of body 103 and smart phone 122. The mobile device/smart phone 122 can be configured with a software application which allows to conduct the necessary calculation for obtaining the desired electrical currents from the magnetic fields measured at a multiplicity of magnetic sensors in accordance with the method of the present invention. In this case, the body 103 head comprises merely a microcircuit 126 which essentially controls data acquisition of the magnetic sensors and data transfer towards the mobile device/smart phone 122. This can, for instance, be effected via the physical data connector 123, which can, e.g., be a USB-C connector. It is also possible that data transfer is effected wirelessly, for instance a Bluetooth-connection between the microcircuit 126 and the mobile device/smart phone 122.

**List of Reference Signs**

| | |
|---|---|
| 10 | first embodiment of handheld device |
| 11 | sensor head |
| 12 | U-shaped aperture |
| 13 | inner surface |
| 14 | side inlet |
| 15 | first magnetic sensor |
| 15a | center of first magnetic sensor |
| 16 | second magnetic sensor |
| 16a | center of second magnetic sensor |
| 17 | third magnetic sensor |
| 17a | center of third magnetic sensor |
| 18 | first protrusion |
| 19 | second protrusion |
| 20 | reference magnetic sensor |
| 21 | body |
| 22 | connector |
| 23 | microprocessor |
| 24 | display |
| 25 | control button/knob |
| 26 | handle |
| 30 | cable |
| 31 | first conductor |
| 32 | second conductor |
| 33 | sheath |
| 100 | second embodiment of handheld device |
| 101 | sensor head |
| 102 | variable aperture |
| 103 | body |
| 104 | static first section of sensor head |
| 105 | pivotable second section of sensor head |
| 106 | handle |
| 107 | foot of second section |
| 108 | foot of second section |
| 109 | ball bearing |
| 110 | rotary axis |
| 111 | foot of first section |
| 112 | foot of first section |
| 113 | return spring |
| 114 | recess of first section |
| 115 | recess of second section |
| 116 | inner surface of recess of first section |
| 117 | inner surface of recess of second section |
| 118 | magnetic sensors of first section |
| 119 | magnetic sensors of second section |
| 120 | reference magnetic sensor |
| 121 | reference magnetic sensor |
| 122 | smart phone |
| 123 | data connector |
| 124 | mechanical connector |
| 125 | mechanical connector |
| 126 | microcircuit |
| A | central axis |
| D | diameter of aperture |

**Claims**

**1.** Method for non-intrusive current measurement in a multi-conductor cable, comprising the steps of:

a) arranging a multi-conductor cable having a number (N) of individual conductors in an aperture (12, 102) of a sensor head (11, 101), said aperture having a central axis (A) extending in a third direction (z), said sensor head (11, 101) having an inner surface (13, 116, 117) defining a circumference of said aperture (12, 102) and a multiplicity of magnetic sensors (15, 16, 17, 118, 119) arranged at a number (L) of different locations at said inner surface (13, 116, 117), said number (L) of different locations being larger than said number (N) of individual conductors;

b) performing a number (M) of measurements at a sampling frequency (fs) of a magnetic field ($\vec{H}$) in a first direction (x) making a first angle with said third direction (z) and in a different second direction (y) making a second angle with said third direction (z), at each of said number (L) of different locations, to obtain said number (M) of measurement data for each of said first and second directions (x, y);

c) performing a harmonic analysis, preferably a discrete Fourier transformation, on each set of said number (M) of measurement data for each of said first and second directions (x, y) to obtain frequency distributions of said measurement data;

d) determining a current frequency (fc) of electrical currents (I) flowing in said multi-conductor cable;

e) selecting magnetic field amplitude coefficients which correspond to said current frequency (fc) from said frequency distributions of said measurement data to obtain a first component ($H_x$) of said magnetic field ($\vec{H}$) in said first direction (x) and of a second component ($H_y$) of said magnetic field ($\vec{H}$) in said second direction (y) at each of said number (L) of different locations; and

f) calculating electrical currents values ($I_j$) for currents flowing in each conductor of said multi-conductor cable from said first and second components ($H_x$, $H_y$) of said magnetic field ($\vec{H}$) at each of said number (L) of different locations.

2. The method of claim 1 further comprising the step of
g) displaying said calculated electrical current values ($I_j$).

3. The method of claim 2, wherein said steps b) to g) are repeated during consecutive measurement cycles.

4. The method of one of claims 1 to 3, wherein said discrete Fourier transformation in step c) is a Fast Fourier Transformation (FFT).

5. The method of claim 4, wherein said number (M) of measurements is selected from the group consisting of 128, 256, 512, 1024 and 2048.

6. The method of one of claims 1 to 5, wherein said sampling frequency (fs) is selected from a range of 200 Hz to 3.2 kHz.

7. The method of one of claims 1 to 6, wherein said first direction (x) is perpendicular to said third direction (z) and said second direction (y) is perpendicular to said third direction (z) and wherein said step b) further comprises performing said number (M) of measurements at said sampling frequency (fs) of a magnetic field ($\vec{H}$) in said third direction (z).

8. The method of one of claims 1 to 7, wherein said sensor head (11, 101) further comprises at least one reference magnetic sensor (20, 120, 121) spaced apart from said inner surface (13, 116, 117) of said aperture (12, 102) of said sensor head (11, 101) and wherein said first and second components ($H_x$, $H_y$) of said magnetic field ($\vec{H}$) are obtained by including corrections ($Href_x$, $Href_y$) obtained from said at least on reference magnetic sensor (20, 120, 121).

9. The method of one of claims 1 to 8, wherein in step d) said current frequency (fc) is a pre-selected current frequency.

10. The method of one of claims 3 to 8, wherein in step d) said current frequency (fc) is determined by varying said sampling frequency (fs) in step b) in consecutive measurement cycles and by selecting in step e) the frequency having the largest magnetic field amplitude coefficient as the current frequency (fc).

**11.** The method of one of claims 1 to 10, wherein in step f), said electrical currents values ($I_j$) for currents flowing in each conductor of said multi-conductor cable are calculated from a trained artificial intelligence model.

**12.** The method of one of claims 1 to 10, wherein in step f), said electrical currents values ($I_j$) for currents flowing in each of said *N* conductors of said multi-conductor cable are calculated from magnetic field measurements of said number (*L*) *of* magnetic sensors for the x- and y-components, respectively, arranged at different locations, by numerically solving equations

$$H_{ix} = -\frac{1}{2\pi}\left(\sum_{j=1}^{N} I_j \frac{\Delta y_{ij}}{r_{ij}^2}\right)$$

and

$$H_{iy} = \frac{1}{2\pi}\left(\sum_{j=1}^{N} I_j \frac{\Delta x_{ij}}{r_{ij}^2}\right)$$

for *i= 1 to L*, wherein $r_{ij}$ is the distance between magnetic sensor *i* and conductor *j* and $\Delta x_{ij}$ and $\Delta y_{ij}$ are the respective x- and y-components of said distance.

**13.** A handheld device for non-intrusive current measurement in a multi-conductor cable comprising:

a sensor head (11,101) comprising an aperture (12,102) defined by an inner surface (13,116,117) of said sensor head (11,101), said aperture (12,102) having an inner diameter (D) and a central axis (A), and a multiplicity of magnetic sensors (15,16,17,118,119) arranged at a number of different locations at said inner surface (13,116,117),
a processing unit (23,126) functionally connected with said multiplicity of magnetic sensors (15,16,17,118,119), said processing unit (23,122,126) being configured to execute steps b) to f) of the method of one of claims 1 to 12.

**14.** The handheld device of claim 13, where said aperture (102) is defined by at least two sections (104,105) of said sensor head (102) which are movable with respect to each other in order to provide an aperture with variable diameter (D).

**15.** The handheld device of one of claims 13 and 14, where said processing unit comprises a micro-ciruit (126) arranged in said sensor head (102) and a mobile device (122) removably connectable to said sensor head (102).

*Fig. 1*

*Fig. 2*

Europäisches
Patentamt

European
Patent Office

Office européen
des brevets

# EUROPEAN SEARCH REPORT

**Application Number**

EP 23 16 6603

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | WO 2013/068360 A1 (UNIV LYON 1 CLAUDE BERNARD [FR]; LYON ECOLE CENTRALE [FR] ET AL.) 16 May 2013 (2013-05-16) * page 4, line 25 – page 11, line 2 * | 1-15 | INV. G01R15/20 G01R19/00 G01R19/25 |
| A | DE 10 2018 116616 A1 (ENLYZE GMBH [DE]) 16 January 2020 (2020-01-16) * paragraphs [0001], [0009] – [0034]; figures 1-3 * | 1-15 | |
| A | US 2019/195917 A1 (TUNG MEAN-JUE [TW] ET AL) 27 June 2019 (2019-06-27) * paragraphs [0025] – [0043]; figures 1-6 * | 1-15 | |
| A | WO 2018/209436 A1 (UNIV ALBERTA [CA]) 22 November 2018 (2018-11-22) * paragraphs [0003] – [0007], [0018] – [0021], [0027] – [0028], [0035] – [0037], [0053]; figures 1-6 * * paragraphs [0065] – [0072], [0082] – [0088] * | 1-15 | TECHNICAL FIELDS SEARCHED (IPC)  G01R |
| A | GENG GUANGCHAO ET AL: "Noninvasive Current Sensor for Multicore Cables", IEEE TRANSACTIONS ON POWER DELIVERY, IEEE SERVICE CENTER, NEW YORK, NY, US, vol. 33, no. 5, 1 October 2018 (2018-10-01), pages 2335-2343, XP011690580, ISSN: 0885-8977, DOI: 10.1109/TPWRD.2018.2813540 [retrieved on 2018-09-21] * paragraph [000I] – paragraph [0V.A]; figures 1-7 * | 1-15 | |

The present search report has been drawn up for all claims

| Place of search | Date of completion of the search | Examiner |
|---|---|---|
| Munich | 11 September 2023 | Maric, Viktor |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 16 6603

This annex lists the patent family members relating to the patent documents cited in the above-mentioned European search report.
The members are as contained in the European Patent Office EDP file on
The European Patent Office is in no way liable for these particulars which are merely given for the purpose of information.

11-09-2023

| Patent document cited in search report | Publication date | Patent family member(s) | Publication date |
|---|---|---|---|
| WO 2013068360 A1 | 16-05-2013 | EP 2776853 A1<br>FR 2982672 A1<br>WO 2013068360 A1 | 17-09-2014<br>17-05-2013<br>16-05-2013 |
| DE 102018116616 A1 | 16-01-2020 | DE 102018116616 A1<br>WO 2020011858 A1 | 16-01-2020<br>16-01-2020 |
| US 2019195917 A1 | 27-06-2019 | NONE | |
| WO 2018209436 A1 | 22-11-2018 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20120319676 A1
- WO 2015144541 A2
- WO 2013068360 A1